# EUROPEAN PATENT SPECIFICATION

(11) **EP 1 156 135 B1**
(45) Date of publication and mention of the grant of the patent: **27.02.2008**
(21) Application number: 01112150.6
(22) Date of filing: 17.05.2001
(51) Int. Cl.: C23C 16/44, C23C 16/54, C23C 14/56, C30B 25/14

(54) **Vacuum processing apparatus**
Vakuumbehandlungsvorrichtung
Dispositif de traitement sous vide

(30) Priority: 18.05.2000 JP 2000146072; 12.06.2000 JP 2000176012
(43) Date of publication of application: 21.11.2001
(73) Proprietor: NIHON SHINKU GIJUTSU KABUSHIKI KAISHA, Chigasaki-shi, Kanagawa 253-8543 (JP)
(72) Inventor: Masuda Takeshi, Kanagawa 243-0213 (JP); Yamada Takakazu, Shizuoka 410-1102 (JP); Uematsu Masaki,, Nagaizumimachi Suntou-gunShizuoka411-0942 (JP); Suu Koukou, Inba-gun ,Chiba 286 0201 (JP)
(74) Representative: Körber, Wolfhart

(56) References cited:
- WO-A-98/39495
- PATENT ABSTRACTS OF JAPAN vol. 1996, no. 02, 29 February 1996 (1996-02-29) & JP 07 273101 A (TOKYO ELECTRON LTD;OTHERS: 01), 20 October 1995 (1995-10-20)
- PATENT ABSTRACTS OF JAPAN vol. 011, no. 297 (C-448), 25 September 1987 (1987-09-25) & JP 62 089881 A (HITACHI LTD), 24 April 1987 (1987-04-24)
- PATENT ABSTRACTS OF JAPAN vol. 018, no. 158 (E-1525), 16 March 1994 (1994-03-16) & JP 05 335280 A (SONY CORP), 17 December 1993 (1993-12-17)

## Description

### BACKGROUND OF THE INVENTION

### 1. Field of the invention

The present invention relates to a vacuum apparatus, and particularly to an apparatus for introducing gas into vacuum atmosphere wherein an object is processed in vacuum.

### 2. Detailed Description of the Related Art

A vacuum processing apparatus of the prior art will be described below taking a CVD apparatus as an example.

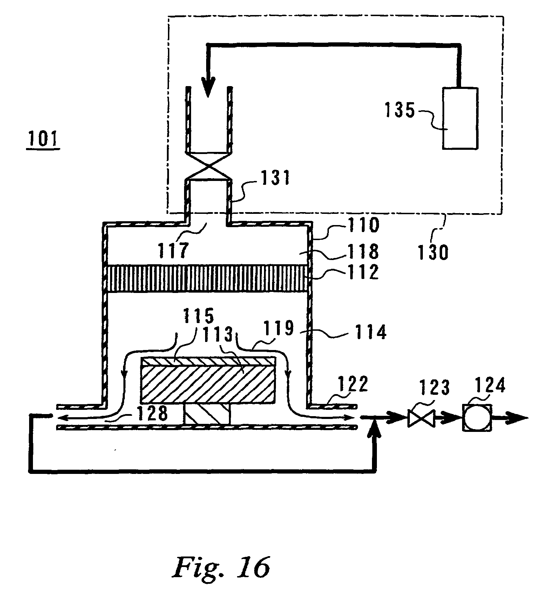

Reference numeral 101 in Fig.16 denotes the vacuum processing apparatus of the prior art. The vacuum processing apparatus 101 has a vacuum vessel 110.

The vacuum vessel 110 has an inlet port 117 provided in the ceiling thereof. The inlet port 117 is connected to a raw material gas generation system 135 via a feed tube 131.

A shower plate 112 is disposed at a position lower than the inlet port 117 in the vacuum vessel 110. There is a clearance between the shower plate 112 and the ceiling of the vacuum vessel 110, the clearance constituting a gas storing chamber 118.

A space between the shower plate 112 and the bottom of the vacuum vessel 110 constitutes a reaction chamber 114, and a substrate stage 113 is provided on the bottom of the vacuum vessel 110 at the lowest position in the reaction chamber 114.

An exhaust port 128 is provided in the side wall of the reaction chamber 114 at a position lower than the substrate stage 113. The exhaust port 128 is connected to a vacuum pump 124 via an exhaust tube pipe 122. The exhaust tube 122 is fitted with a pressure regulating valve 123 installed therein at a position between the vacuum pump 124 and the exhaust port 128.

In order to form a thin film on a substrate surface in the vacuum processing apparatus 101, first the pressure regulating valve 123 is fully opened to pump the inside of the vacuum vessel 110 to be vacuum, and the substrate is carried into the reaction chamber 114. When carrying in the substrate, the atmosphere in the vacuum vessel 110 is maintained vacuum.

Reference numeral 115 in Fig.16 denotes the substrate being carried into the reaction chamber 114 and placed on the substrate stage 113. The substrate 115 is heated to a predetermined temperature by a heater installed in the substrate stage 113.

Then the extent of opening the pressure regulating valve 123 is decreased, and a raw material gas for depositing of the thin film is introduced from the gas introduction system 130 into the storing chamber 118. The raw material gas which has filled the gas storing chamber 118 passes small holes of the shower plate 112 and diffuses in the reaction chamber 114. When the raw material gas reaches the surface of the substrate 115, chemical reaction takes place on the substrate 115 surface so that a thin film grows thereon.

Arrow 119 indicates the flow of the raw material gas before reaction and the flow of the waste gas after reaction. The raw material gas which is introduced through the small holes of the shower plate 112 into the reaction chamber 114 is, upon impinging on the surface of the substrate 115, directed toward the outside of the substrate 115 to pass the clearance between a side face of the substrate stage 113 and the wall surface of the vacuum vessel 110, thereby to reach the exhaust port 128.

When the thin film having the predetermined thickness has been deposited on the surface of the substrate 115, introduction of the raw material gas is stopped and the pressure regulating valve 123 is fully opened thereby to remove the raw material gas remaining in the reaction chamber 114 and in the gas storing chamber 118 by vacuum pumping.

However, since preference is placed on the pressure controllability during growth of the thin film in the vacuum processing apparatus 101 of such a constitution as described above, the pressure regulating valve 123 used is of such a type that is capable of precisely controlling the extent of opening.

Also the residual gas in the reaction chamber 114 flows between the substrate stage 113 and the wall surface of the vacuum vessel 110 when evacuated, and therefore conductance of evacuation thereof is low and the gas is likely to remain in the reaction chamber 114.

When the substrate 115 is carried out with the gas remaining in the vacuum vessel 110, the residual gas enters the transfer chamber to which the substrate is moved. The residual gas further enters the other units of the vacuum processing apparatus via the transfer chamber.

When a thin film is deposited by using an organometal gas in the MOCVD process, in particular, the raw material gas which has entered the transfer chamber adsorbs onto the wall surface thereof since the wall of the transfer chamber is cold. Since the raw material gas adsorbing onto the wall surface is not re-evaporated and the adsorbed raw material gas on the wall surface is emitted by degrees for a long, it degrades the degree of vacuum in the transfer chamber, making a cause of contamination.

WO 98/39495 discloses a vacuum processing apparatus according to the preamble of independent claim 1. JP 07 273101 A and JP 62 089881 A disclose known multi-chamber vacuum processing apparatuses.

The vacuum processing apparatus wherein an object is processed in vacuum by using a gas, as described above, is required to provide vacuum ambient pressure to be high during vacuum processing and decrease the pressure as low as possible when evacuating the remaining gas.

### SUMMARY OF THE INVENTION

The present invention has been completed to solve the problems described above, and an object thereof is to provide a vacuum processing apparatus capable of increasing the speed of evacuating the residual gas.

In order to solve the problems described above, the present invention provides a vacuum processing apparatus according to claim 1, including a vacuum vessel, a substrate stage disposed in the vacuum vessel, a stage moving mechanism for moving the substrate within the vacuum vessel, a vacuum pumping system for evacuating the inside of the vacuum vessel, and a gas introduction system for introducing gas into the vacuum vessel. The vacuum vessel is divided into a reaction chamber and an assistance chamber which communicate with each other, while the conductance of evacuation when the substrate stage with a substrate placed thereon is positioned in the reaction chamber is lower than the conductance of evacuation when the substrate stage is positioned in the assistance chamber, wherein a ring-shaped contact member is provided on the inner wall surface of the vacuum vessel located between the reaction chamber and the assistance chamber so that, when the substrate stage is moved toward the reaction chamber, the substrate placed on the surface of the substrate stage is exposed to the inside of the reaction chamber through a central position of the contact member and, at the same time, a contact portion of the substrate stage and the contact member are brought into close contact with each other, and wherein a small hole is provided in the contact member so that, when the contact portion of the substrate stage and the contact member are brought into close contact with each other, the reaction chamber and the assistance chamber communicate with each other via the small hole.

In the vacuum processing apparatus of the present invention, the gas introduction system may be connected to the reaction chamber.

In the vacuum processing apparatus of the present invention, the gas introduction system may be constituted so as to introduce the gas to the reaction chamber from the top thereof.

The vacuum processing apparatus of the present invention may also have such a constitution as the gas introduction system is provided with a gas generation system which generates a raw material gas including an organometal compound, while the raw material gas is introduced into the reaction chamber.

In the vacuum processing apparatus of the present invention, the assistance chamber may be disposed below the reaction chamber.

The vacuum processing apparatus of the present invention may also have such a constitution as the vacuum pumping system is connected to the assistance chamber, so that the gas introduced into the reaction chamber is evacuated through the assistance chamber by vacuum pumping.

The vacuum processing apparatus of the present invention may also have such a constitution as a substrate loading/unloading port is provided in the wall of the assistance chamber, so that the substrate can be placed on the substrate stage via the substrate loading/unloading port while the substrate stage is positioned in the assistance chamber.

The vacuum processing apparatus of the present invention may also have such a constitution as a heating device is provided in the vacuum vessel for heating the reaction chamber and the assistance chamber.

The vacuum processing apparatus of the present invention may also constitute a multi-chamber vacuum processing apparatus which includes at least one unit of the vacuum processing apparatus described above, a heating chamber for heating substrate in vacuum atmosphere and a transfer chamber in which the substrate is moved in vacuum atmosphere, while the vacuum processing apparatus and the heating chamber are connected to the transfer chamber.

In the multi-chamber vacuum processing apparatus, a sputtering apparatus may be connected to the transfer chamber.

The present invention has the constitution as described above, where the stage moving mechanism moves the substrate stage in the vacuum vessel while maintaining vacuum atmosphere.

The system is so designed that the conductance of evacuation between the reaction chamber and the exhaust port is lower when the inside of the vacuum vessel is evacuated while the substrate stage is moved toward the reaction chamber, than when the inside of the vacuum vessel is evacuated while the substrate stage is moved into the assistance chamber.

In the vacuum processing apparatus of the present invention, the gas introduction system for introducing the raw material gas may be connected to the reaction chamber and the evacuation system may be connected to the assistance chamber. In this case, pressure of the raw material gas in the reaction chamber can be made higher even when the pressure in the assistance chamber is low, by moving the substrate stage toward the reaction chamber and introducing the raw material gas into the reaction chamber while evacuating the inside of the assistance chamber by means of the vacuum pumping system.

Since the conductance of evacuation becomes higher when the introduction of the raw material gas is stopped and the substrate stage is moved into the assistance chamber, residual gas in the reaction chamber can be rapidly removed to the outside.

### BRIEF DESCRIPTION OF THE DRAWINGS

Fig.1 shows the vacuum processing apparatus of a first general example ;
Fig.2 shows the operation of transferring the substrate into the vacuum processing apparatus;
Fig.3 shows the state of completing the transfer of the substrate into the vacuum processing apparatus;
Fig.4 shows the state of growing the thin film in the vacuum processing apparatus;
Fig.5 shows the state of evacuating residual gas in the vacuum processing apparatus;
Fig.6(a) shows the clearance between the substrate stage and the wall surface of the vacuum vessel when the substrate stage is elevated;
Fig.6(b) shows the clearance between the substrate stage and the wall surface of the vacuum vessel when the substrate stage is moved into the assistance chamber;
Fig.7 shows the vacuum processing apparatus of an embodiment of the present invention;
Fig.8 shows the state of growing the thin film in the embodiment of the vacuum processing apparatus;
Fig.9 shows the vacuum processing apparatus of further general example ;
Fig.10 shows the state of growing the thin film in the further general example of the vacuum processing apparatus;
Fig. 11 is a graph showing the difference in the evacuation characteristic between the vacuum processing apparatus of the prior art and the vacuum processing apparatus of the present invention;
Fig.12 is a graph showing the difference in the film thickness distribution between the vacuum processing apparatus of the prior art and the vacuum processing apparatus of the present invention;
Fig.13 is a graph showing the difference in the electric characteristic of the thin film between the vacuum processing apparatus of the prior art and the vacuum processing apparatus of the present invention;
Fig.14 is a block diagram showing an example of the gas generation system which can be used in the present invention;
Fig.15 shows the multi-chamber vacuum processing apparatus as an example of the present invention; and
Fig. 16 shows the vacuum processing apparatus of the prior art.

### DETAILED DESCRIPTION OF THE PREFERRED EMBODIMENTS

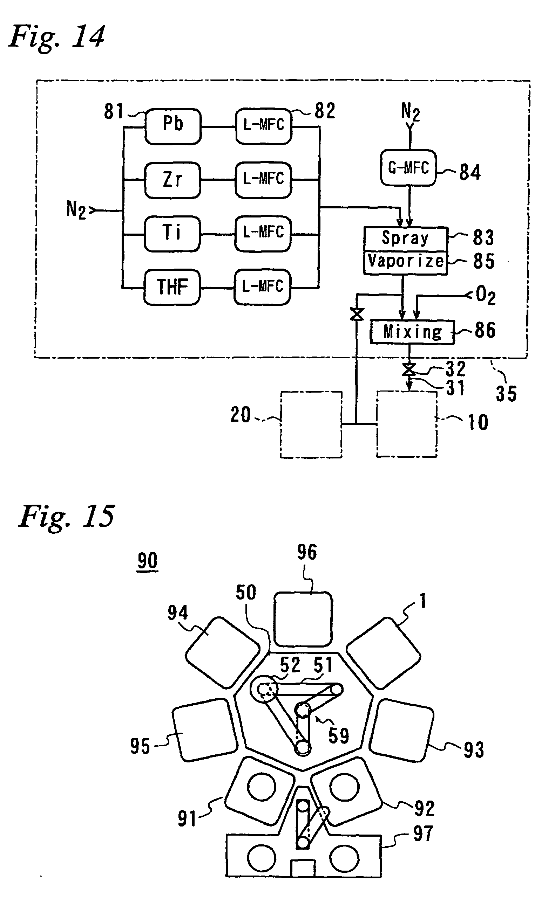

Reference numeral 90 in Fig.15 denotes a multi-chamber vacuum processing apparatus as an example of the present invention.

The multi-chamber vacuum processing apparatus 90 includes a transfer chamber 50, a loading chamber 91, an unloading chamber 92, sputtering chambers 93, 94, a plasma cleaning chamber 95, a heating chamber 96 and the vacuum processing apparatus 1 of a first example of the present invention, while the chambers 1 and 91 through 96 are connected to the transfer chamber 50.

Reference numeral 97 denotes an automatic loader which is used to place an unprocessed substrate into the loading chamber 91, and take out the substrate which has been returned into the unloading chamber 92 after being processed in the multi-chamber vacuum processing apparatus 90. Reference numeral 59 denotes a substrate transfer robot installed in the transfer chamber 50. The substrate transfer robot 59 can operate while maintaining the vacuum atmosphere in the transfer chamber 50.

Now the vacuum processing apparatus 1 of a first general example will be described below.

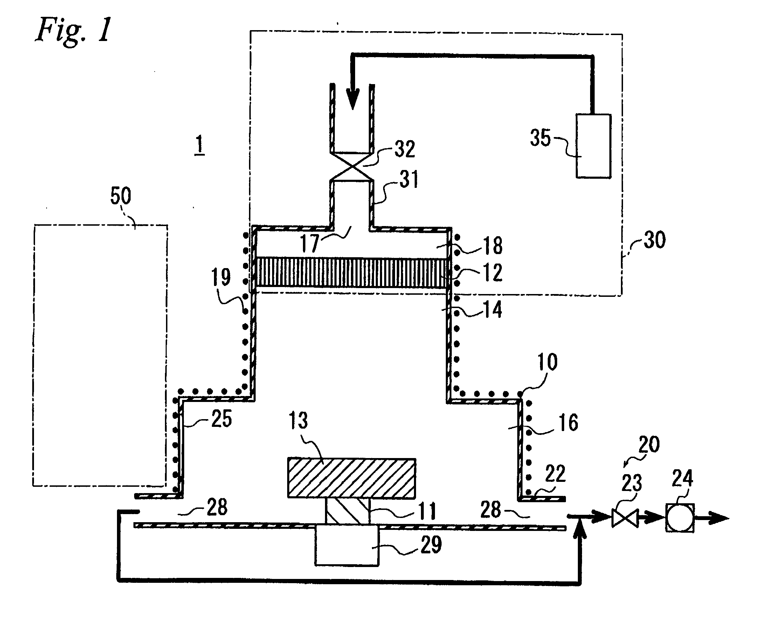

Referring to Fig.1, the vacuum processing apparatus 1 includes a vacuum vessel 10, a gas introduction system 30 and a vacuum pumping system 20.

The gas introduction system 30 includes a gas generation system 35 which generates a raw material gas for thin film depositing a feed tube 31 extending from the gas generation system 35, an inlet port 17 provided in the ceiling of the vacuum vessel 10 and connected to an end of the feed tube 31, and a shower plate 12 installed in the vacuum vessel 10 near the ceiling. There is a space between the shower plate 12 and the ceiling of the vacuum vessel 10, forming a gas storing chamber 18.

Installed airtight to penetrate the bottom plate of the vacuum vessel 10 is a lift shaft 11 with the substrate stage 13 attached on top end thereof. A stage moving mechanism 29 is disposed outside the vacuum vessel 10, while the lower portion of the lift shaft 11 is put into the stage moving mechanism 29 so as to be moved up and down by the stage moving mechanism 29 while maintaining the vacuum atmosphere in the vacuum vessel 10.

By the lift shaft 11 is moved vertically, the substrate stage 13 moves between a position near the bottom of the vacuum vessel 10 and a position near the shower plate 12.

Provided in a side wall of the vacuum vessel 10 at a position near the bottom is an exhaust port 28 for the vacuum pumping system 20. Connected to the exhaust port 28 is an end of an exhaust tube 22 of which another end is connected to the vacuum pump 24. A gate valve 23 is provided between the vacuum pump 24 and the exhaust port 28, so that the residual gas in the vacuum vessel 10 is pumped out through the exhaust port 28 when the vacuum pump 24 is operated and the gate valve 23 is opened.

The vacuum vessel 10 has such a configuration as the upper portion of the vacuum vessel 10 wherein the shower plate 12 is installed has a cylindrical shape, and the lower portion to which the vacuum pumping system 20 is connected has a shape of rectangular-section tube. Reference numeral 14 denotes a reaction chamber constituted from the interior space of the cylindrical portion. Reference numeral 16 denotes an assistance chamber constituted from the inner space of the rectangular-section tube. The vacuum vessel 10 is wider in each side of the portion which constitutes the assistance chamber 16 than in the diameter of the portion which constitutes the reaction chamber 14.

The vacuum vessel 10 also has a substrate loading/unloading port 25, which can freely open or close, in a side wall of the portion thereof which constitutes the assistance chamber 16. The vacuum processing apparatus 1 is connected by the substrate loading/unloading port 25 with the transfer chamber 50.

Fig.14 is a block diagram of the gas generation system 35 used for carrying out the MOCVD process by means of the vacuum processing apparatus 1 described above.

The gas generation system 35 has a plurality of raw material containers 81. Operation for depositing a thin film of ferroelectric lead zirconate titanate (PZT) in the vacuum vessel 10 will be described below. First, organometal compounds each including one of Pb, Zr and Ti in the chemical composition thereof are dissolved in an organic solvent (THF):Tetrahydro-furan thereby to prepare three kinds of stock solution which are stored in different raw material containers 81. The organic metal compounds are (1) through (3) described below.
(1) Lead bis(dipivaloylmethanate): Pb(DPM)₂
(2) Zirconium tetrakis(dipivaloylmethanate): Zr(DPM)₄
(3) Di-isopropoxy-titanium bis(dipivaloylmethanate): Ti(iPrO)₂(DPM)₂

Each of the raw material containers 81 is connected via a liquid mass flow controller 82 to a spray device 83. The spray device 83 has such a constitution as the stock solutions in the raw material containers 81 can be introduced therein at controlled flow rates.

The spray device 83 is also connected to a carrier gas cylinder via a gas mass flow controller 84, so that a carrier gas (nitrogen gas in this case) can also be introduced at a controlled flow rate concurrently with the introduction of the stock solutions.

As the stock solutions introduced into the spray device 83 are sprayed along with the carrier gas into an evaporator 85, the stock solution evaporates.

The evaporator 85 is connected to a mixer 86, so that the carrier gas and the gases of the evaporated stock solutions can be introduced into the mixer 86.

Also connected to the mixer 86 is a cylinder filled with a reaction gas (O₂ gas in this case), so that the gases are mixed to generate the raw material gas, when the reaction gas as well as the carrier gas and the gases of the evaporated stock solutions are introduced into the mixer.

The mixer 86 is connected by the feed tube 31 to the inlet port 17, with the valve 32 installed amid the line. When the valve 32 is opened while the raw material gas is generated in the mixer 86, the raw material gas is introduced into the gas storing chamber 18 via the feed tube 31.

The multi-chamber vacuum processing apparatus 90 and the vacuum processing apparatus 1 of the first general example are comprised as described above. To deposit a thin film of PZT, first the sputtering chambers 93, 94, the plasma cleaning chamber 95, the heating chamber 96 and the vacuum processing apparatus 1 are pumped vacuum in advance. Then after loading the substrate, whereon the film is to be deposited in the loading chamber 91 by the automatic loader 97, and evacuating the loading chamber 91, the substrate transfer robot 59 is operated to load the substrate into the heating chamber 96. The substrate is heated to a predetermined temperature (600°C) in the heating chamber 96.

In the vacuum processing apparatus 1 of the first general example, a heating device 19 provided around the exterior walls of the vacuum vessel 10 is operated to heat up the wall of the vacuum vessel 10 to a predetermined temperature (220°C) while evacuating the inside of the vacuum vessel 10 by the vacuum pumping system 20.

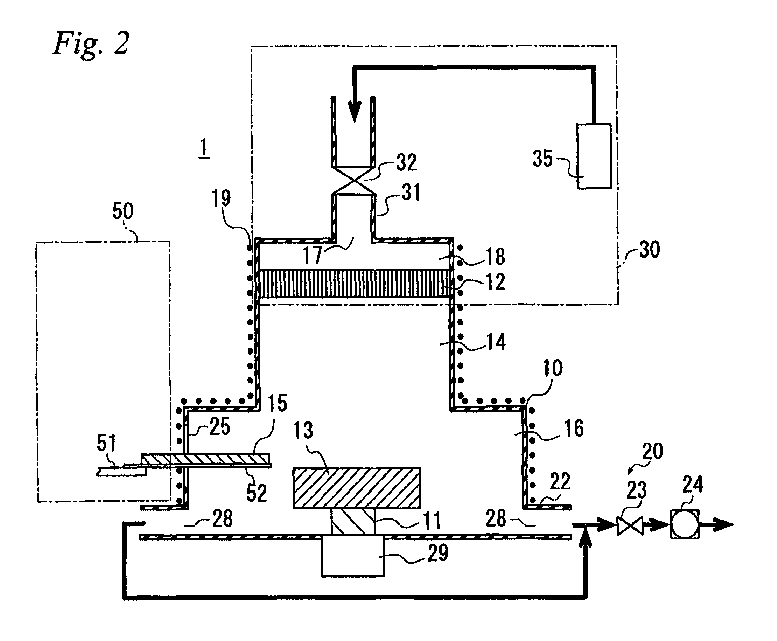

Meanwhile the stage moving mechanism 29 is operated to lower the substrate stage 13 into the assistance chamber 16 as shown in Fig.2.

Then after opening the substrate loading/unloading port 25, the substrate which has been heated in the heating chamber 96 is carried by the substrate transfer robot 59 into the assistance chamber 16 of the vacuum vessel 10.

Reference numeral 51 in Fig.2 denotes an arm of the substrate transfer robot 59, with the substrate 15 being placed at a distal end 52 of the arm 51.

The distal end 52 is positioned over the substrate stage 13 and the substrate 15 is transferred onto the substrate stage 13 by means of a substrate lifting mechanism not shown. Then after the arm 51 and the distal end 52 thereof are pulled out of the vacuum vessel 10, the substrate loading/unloading port 25 is closed so as to attain the state of the substrate 15 being placed in the vacuum processing apparatus 1.

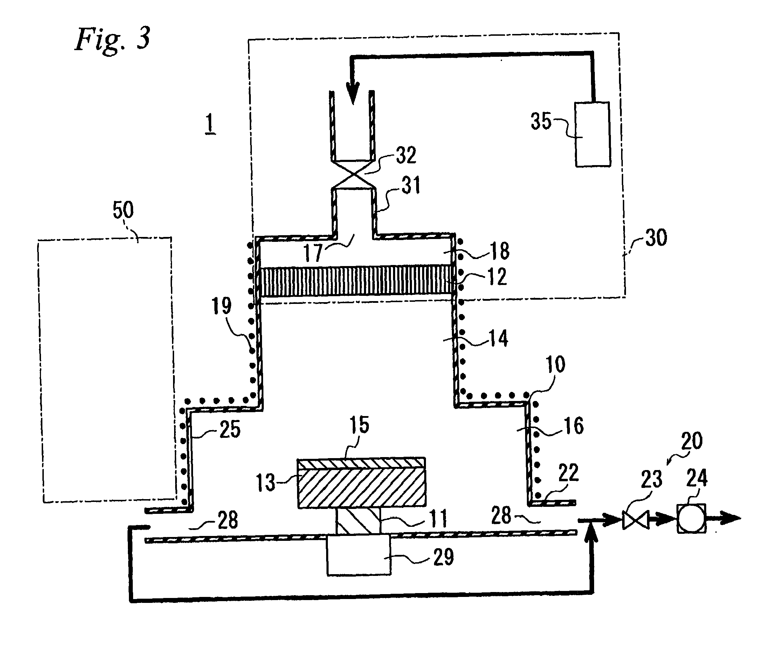

Fig.3 shows the state described above. The substrate stage 13 incorporates the heating device therein, so that the substrate 15 placed on the substrate stage 13 is maintained at a predetermined temperature by the heating device.

In this state and during growth of the thin film to be described later, too, the vacuum pump 24 is always in operation, and the gas existing in the vacuum vessel 10 is exhausted through the exhaust port 28.

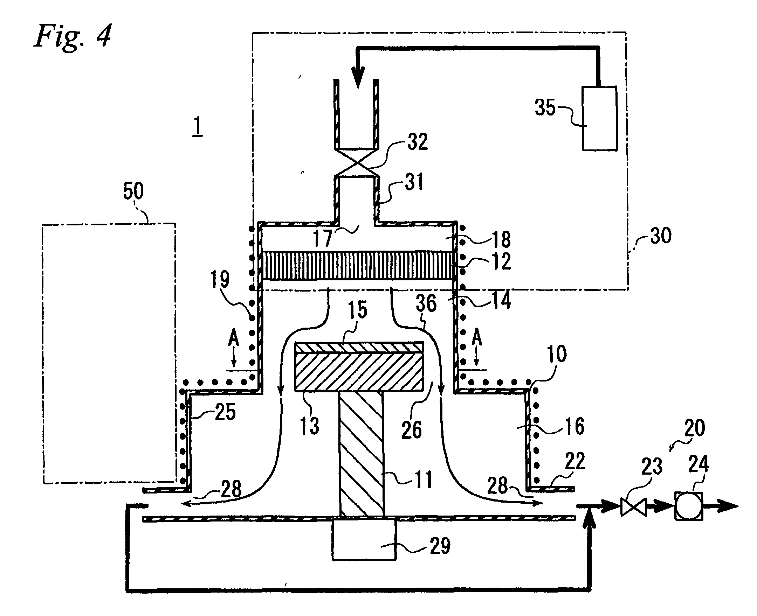

Then the substrate stage 13 is elevated by the stage moving mechanism 29, thereby to put the substrate 15 placed on the substrate stage 13 in the reaction chamber 14 as shown in Fig. 4.

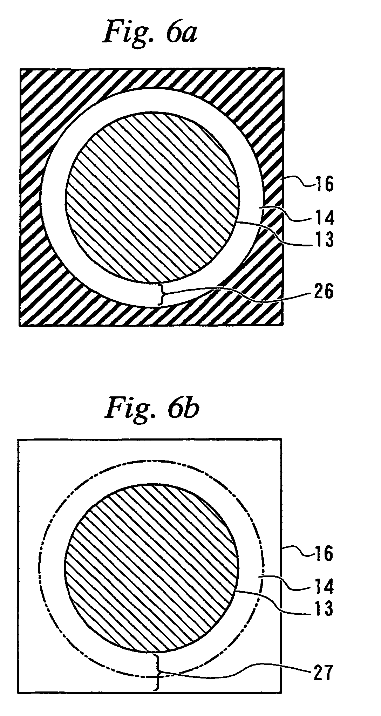

Fig.6(a) is a schematic sectional view taken along line A-A of the reaction chamber 14 in the state shown in Fig.4 (the substrate stage 13 being elevated). The substrate stage 13 has a disk shape of a diameter 2mm smaller than that of the reaction chamber 14. Accordingly, clearance 26 between the side face of the substrate stage 13 and the wall surface of the vacuum vessel 10 is about 1mm.

In this state, the raw material solutions of compounds including Pb, Zr and Ti (the compounds were dissolved in THF as the solvent with the concentration adjusted to 0.3 mol/liter) held in the raw material containers 81 were introduced at proper flow rates into the evaporator 85, while the carrier gas (N₂ gas) was introduced at a flow rate of 300 sccm into the evaporator 85 at the same time.

The raw material solutions were evaporated in the evaporator 85, and introduced into the mixer 86 together with the reaction gas (O₂ gas) of 2000 sccm, thereby to generate the raw material gas in the mixer 86, and then the valve 32 was opened to introduce the gas into the gas storing chamber 18.

The shower plate 12 has small holes so that the raw material gas introduced into the gas storing chamber 18 passes through the small holes of the shower plate 12 and sprayed into the reaction chamber 14.

The raw material gas sprayed into the reaction chamber 14 diffuses in the reaction chamber 14 and, upon reaching the surface of the substrate 15, undergoes chemical reaction in the portion of surface so as to deposit a thin film of ferroelectric lead zirconate titanate (PZT) on the surface of the substrate 15.

Reference numeral 36 in Fig.4 indicates the flow of the raw material gas injected through the shower plate 12 into the reaction chamber 14 and the flow of the waste gas after the raw material gas has been used to grow the thin film. These gases pass the narrow clearance 26 between the substrate stage 13 and the vacuum vessel 10, and pass through the assistance chamber 16 to be evacuated through the exhaust port 28.

When the substrate stage 13 is positioned in the reaction chamber 14, the assistance chamber 16 which is directly connected to the exhaust port 28 is evacuated directly by the vacuum pumping system 20 and is therefore pumped to a lower pressure. In contrast, since the clearance 26 has lower conductance, the reaction chamber 14 has lower conductance of evacuation. As a result, the raw material gas injected through the small holes of the shower plate 12 remains in the reaction chamber 14, resulting in a higher pressure in the reaction chamber 14. When the pressure in the assistance chamber 16 was about 133 Pa with the substrate stage 13 being placed in the reaction chamber 14, pressure in the reaction chamber 14 into which the raw material gas was sprayed was 10 times that of the assistance chamber 16.

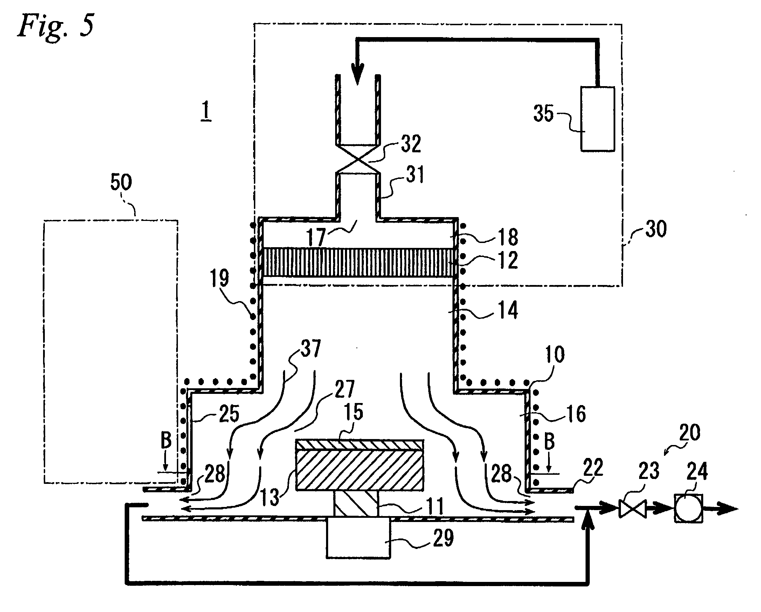

When the thin film grown on the surface of substrate 15 reaches a predetermined thickness, introduction of the raw material gas and heating of the substrate 15 are stopped. Then the stage moving mechanism 29 is actuated to lower the substrate stage 13. Fig.5 shows a state of the substrate stage 13 which has been lowered is positioned in the assistance chamber 16.

Fig.6(b) is a schematic sectional view taken along line B-B of the assistance chamber 16 under this condition. Since width of the assistance chamber 16 is larger than the diameter of the reaction chamber 14, clearance 27 between the side face of the substrate stage 13 and the wall surface of the vacuum vessel 10 is made larger. Thus the conductance of evacuation of the reaction chamber 14 is higher in this state.

Reference numeral 37 in Fig.5 indicates the flow of the raw material gas remaining in the reaction chamber 14 and the flow of the waste gas which pass through the wide clearance 27 and evacuated through the exhaust port 28. Consequently, when the substrate stage 13 is moved into the assistance chamber 16 after introduction of the raw material gas has been stopped, pressure in the vacuum vessel 10 decreases in a short time.

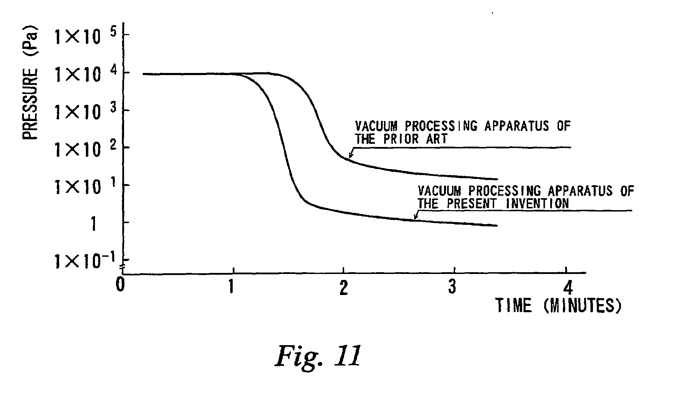

Fig.11 is a graph showing the vacuum pumping characteristic, contrasting the vacuum pumping characteristic of the vacuum processing apparatus 1 of the first general example and the vacuum pumping characteristic of the vacuum processing apparatus 101 of the prior art.

In the vacuum processing apparatus 101 of the prior art, it took 13 minutes since high vacuum pumping was carried out after completing the film deposition, then the substrate was taken out, till the next substrate was carried in and film formation thereon was completed. In contrast, the process was completed in 8 minutes in the vacuum processing apparatus 1 of the first general example

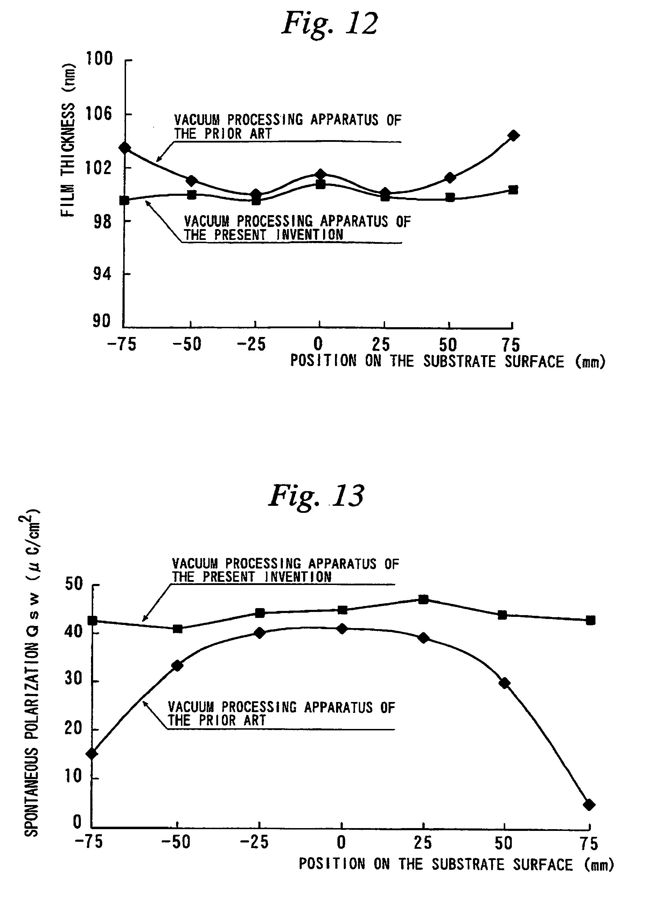

Fig.12 is a graph showing the film thickness distribution of PZT across the surface of the substrate. Point 0 in the scale of abscissa is set at the center of the substrate. Fig.13 is a graph showing the distribution of electric characteristic of the thin film of PZT which has been measured across the surface.

In the vacuum processing apparatus 1 of the first general example, since the raw material gas and the waste gas are rapidly evacuated after completing the deposition of the thin film, the film thickness and the electric characteristic are distributed more uniformly across the surface than in the case of the vacuum processing apparatus 101 of the prior art. In the case of the vacuum processing apparatus 101 of the prior art, in particular, since the raw material gas is likely to stay around the substrate stage when pumping out the residual gas, film thickness becomes greater along the periphery of the substrate and the electric characteristic deteriorates.

Now an embodiment of the vacuum processing apparatus of the present invention will be described below.

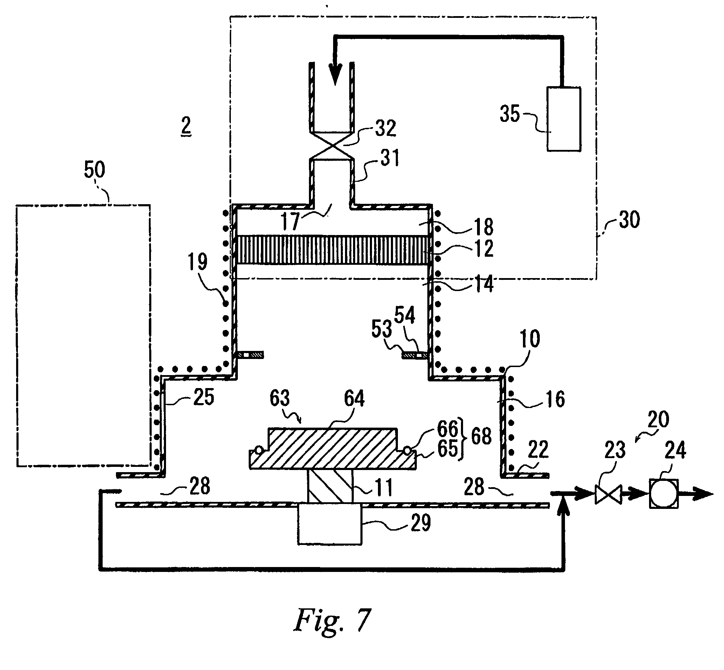

Reference numeral 2 in Fig.7 denotes the vacuum processing apparatus of the embodiment. Members similar to those used in the vacuum processing apparatus 1 of the first general example are denoted with the same reference numerals and description thereof are omitted.

A substrate stage 63 of the vacuum processing apparatus 2 has a mount 64 which has a cylindrical shape with a flat top.

The mount 64 has a contact portion 68 disposed around thereof at the bottom.

The contact portion 68 has a flange 65 of diameter larger than the outer diameter of the mount 64 and an O-ring 66 disposed on the surface of the flange 65.

The cylindrical portion of the vacuum vessel 10 which constitutes the reaction chamber 14 has a diameter larger than that of the flange 65, so that the flange 65 can be disposed in the reaction chamber 14 without making contact with the wall surface of the vacuum vessel 10.

The vacuum vessel 10 is provided with a ring-shaped contact member 53 fastened onto the wall surface of the portion thereof which constitutes the reaction chamber 14.

Inner diameter of the contact member 53 is made larger than the diameter of the mount 64 of the substrate stage 63, while the mount 64 is thicker than the contact member 53.

Center of the contact member 53 and centers of the mount 64 and the flange 65 are aligned on the same vertical line so that, when the stage moving mechanism 29 is actuated to elevate the substrate stage 63 out of the assistance chamber 16, the mount 64 fits into the contact member 53 while the surface of the mount 64 protrudes upward beyond the contact member 53.

The O-ring 66 is provided on the surface of the flange 65 around the mount 64, so that top of the O-ring 66 makes contact with the back surface of the contact member 53 when the mount 64 fits in the contact member 53. Under this condition, the contact member 53 and the substrate stage 63 make close contact with each other. For a high-temperature application, an O-ring made of a metal may be used for the O-ring 66.

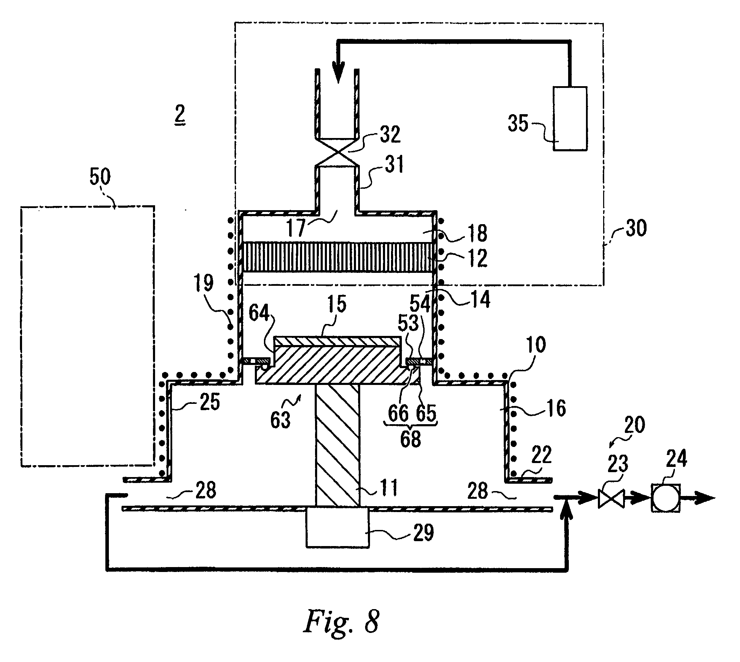

Fig.8 shows the state of the contact member 53 and the substrate stage 63 making close contact with each other, attained by placing the substrate 15 on the mount 64 in the assistance chamber 16, then moving the substrate stage 63 upward. In this state, the surface of the substrate 15 is exposed into the reaction chamber 14.

The contact member 53 has a plurality of holes 54, so that the reaction chamber 14 and the assistance chamber 16 are communicated with each other by the holes 54.

In this state, the space above the contact member 53 constitutes the reaction chamber 14. The raw material gas injected through the small holes of the shower plate 12 fills the reaction chamber 14. Then the raw material gas which has not reacted and the waste gas after reaction enter the assistance chamber 16 through the hole 54, and are exhausted out through the exhaust port 28.

Under this condition, since the reaction chamber 14 has the same conductance of evacuation as that of the holes 54, pressure in the reaction chamber 14 becomes higher than that in the assistance chamber 16.

After the thin film has been deposited, introduction of the raw material gas is stopped and the substrate stage 63 is lowered so that the substrate stage 63 departs from the contact member 53. Thus the distance between the substrate stage 63 and the wall surface of the vacuum vessel 10 increases so that the conductance of evacuation of the reaction chamber 14 increases, and the residual gas in the reaction chamber 14 is rapidly evacuated.

Thus in the vacuum processing apparatus 2 of the embodiment of the present invention, as in the vacuum processing apparatus 1 of the first general example, the conductance of evacuation of the reaction chamber 14 is low when the substrate 15 is positioned in the reaction chamber 14. The conductance of evacuation of the reaction chamber 14 becomes higher when the substrate 15 is retreated into the assistance chamber 16 than the conduction when the substrate 15 is positioned in the reaction chamber.

As a result, pressure of the raw material gas in the reaction vessel 14 can be increased when growing the thin film, while the speed of exhausting of the reaction chamber 14 and the assistance chamber 16 can be increased when evacuating the residual gas.

Particularly in the vacuum processing apparatus 2 of the embodiment, the conductance of evacuation of the reaction chamber 14 when growing the thin film can be controlled by changing the size and number of the holes 54 of the contact member 53.

The vacuum processing apparatus 2 wherein the assistance chamber 16 is located below the reaction chamber 14 has been described, although the present invention is not limited to this constitution.

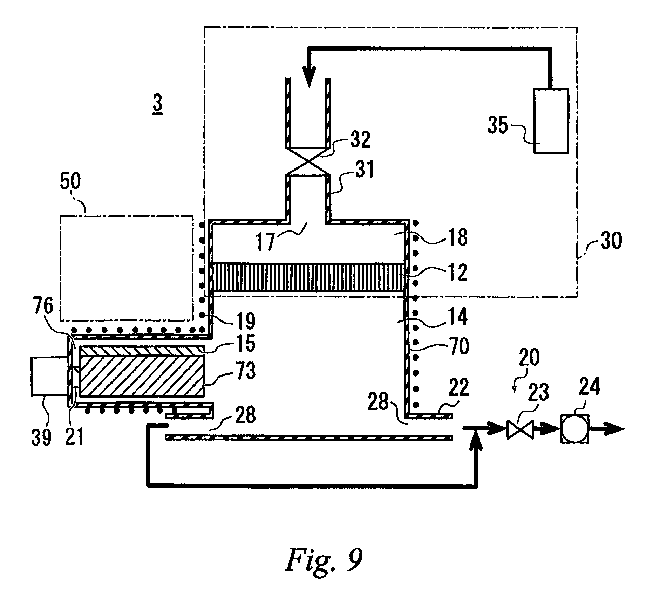

Reference numeral 3 in Fig.9 denotes the vacuum processing apparatus of a further example, having a vacuum vessel 70 wherein an assistance chamber 76 is located at a position sideways below the reaction chamber 14. The inside of the vacuum vessel 70 is evacuated by the vacuum pumping system 20 when carrying in the substrate, when growing the thin film and after the thin film has been deposited, similarly to the cases of the vacuum processing apparatuses 1, 2.

In the vacuum processing apparatus 3, the substrate stage 73 is positioned in the assistance chamber 76 and the substrate 15 is placed on the substrate stage 73. Then the stage moving mechanism 39 is actuated to extend a transfer shaft 21 sideways thereby to move the substrate stage 73 horizontally and put the substrate 15 in the reaction chamber 14.

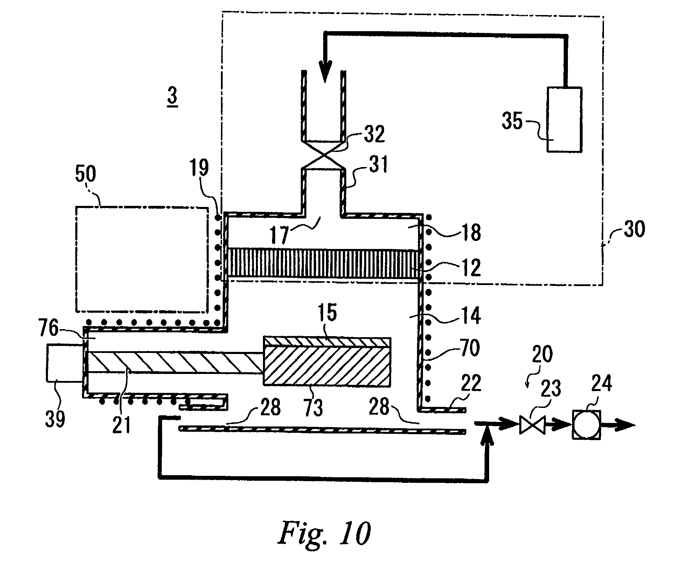

Fig.10 shows the state described above, in which the distance between the substrate 15 and the vacuum vessel 70 is small and therefore the conductance of evacuation of the reaction chamber 14 is low.

As the raw material gas is injected through the small holes of the shower plate 12 into the reaction chamber 14 to deposit the thin film on the substrate 15 and then the substrate stage 73 is retreated into the assistance chamber 76, the conductance of evacuation of the reaction chamber 14 increases so that the residual gas in the reaction chamber 14 is rapidly exhausted by vacuum pumping.

Thus since the conductance of evacuation between the reaction chamber 14 and the exhaust port 28 is high when the substrate stage 73 is retreated into the assistance chamber 76, the residual gas in the reaction chamber 14 is rapidly exhausted by vacuum pumping. The assistance chamber 76 and the reaction chamber 14 may be partitioned from each other when growing the thin film.

Similar effects of uniformity for thickness and distribution of electric characteristic of the thin film have been deposited with other raw materials, for example, in the growth of (Ba, Sr)TiO₃ thin film. The raw materials used in this case were Ba(DPM)₂, Sr(DPM)₂, Ti(iPrO)₂(DPM)₂, of which solutions with a concentration of 0.3 mol/liter were supplied at a flow rate of 0.6 ml/min. The present invention can be applied to the CVD process for wide applications including Pt, Ir, Ru, SrRuO₃, WN and TiN.

The vacuum processing apparatus 2 where the MOCVD process is employed has been described, although the present invention is not limited to this constitution. The present invention can be applied to vacuum processing apparatuses in general wherein gas is introduced into vacuum atmosphere and decomposed on a substrate, and the gas remaining therein after completing the process is rapidly exhaused by vacuum pump. For example, the present invention may also be applied to an etching apparatus or a surface modification apparatus wherein a gas is introduced into vacuum atmosphere.

Time required to exhaust the residual gas is reduced since the conductance of evacuation when pumping out the residual gas can be made higher than that during growth of the thin film.

Since the substrate is transferred into the vacuum processing apparatus after being heated to a predetermined temperature, the period of heating the substrate in the vacuum processing apparatus is eliminated.

## Claims

1. A vacuum processing apparatus (2) comprising:
a vacuum vessel (10);
a substrate stage (13) disposed in said vacuum vessel (10);
a stage moving mechanism (29) for moving said substrate stage (63) within said vacuum vessel (10);
a vacuum pumping system (20) for evacuating the inside of said vacuum vessel; and
a gas introduction system (30) for introducing gas into said vacuum vessel, wherein said vacuum vessel (10) is divided into a reaction chamber (14) and an assistance chamber (16) which communicate with each other, while a conductance of evacuation when a substrate placed on said substrate stage (63) is positioned in said reaction chamber (14) is lower than a conductance of evacuation when said substrate stage (63) is positioned in said assistance chamber (16), wherein a ring-shaped contact member (53) is provided on an inner wall surface of said vacuum vessel (10) between said reaction chamber (14) and said assistance chamber (16), when said substrate stage (63) is moved toward said reaction chamber (14), said substrate placed on a surface of said substrate stage (63) is exposed to an inside of said reaction chamber (14) through a central position of said contact member and, at the same time, a contact portion (68) of said substrate stage (63) and said contact member (53) are brought into close contact with each other,
**characterized in, that**, small holes (54) are provided in said contact member (53) so that, when the contact portion (68) of said substrate stage (63) and said contact member (53) are brought into close contact with each other, said reaction chamber (14) and said assistance chamber (16) communicate with each other via said small holes (54).

2. The vacuum processing apparatus (2) according to claim 1, wherein said gas introduction system (30) is connected to said reaction chamber (14).

3. The vacuum processing apparatus (2) according to claim 2, wherein said gas introduction system (30) is constituted so as to introduce the gas through top of said reaction chamber (14).

4. The vacuum processing apparatus (2) according to claim 3, wherein said gas introduction system (30) is provided with a gas generation system (35) which generates a raw material gas comprising an organometal compound, said raw material gas being introduced into said reaction chamber (14).

5. The vacuum processing apparatus (2) according to one of the claims 1 to 4, wherein said assistance chamber (16) is disposed below said reaction chamber (14).

6. The vacuum processing apparatus (2) according to one of the claims 1 to 5, wherein said vacuum pumping system (20) is connected to said assistance chamber (16), so that the gas introduced into said reaction chamber (14) is exhausted through said assistance chamber (16).

7. The vacuum processing apparatus (2) according to one of the claims 1 to 6, wherein a substrate loading/unloading port (25) is provided in the wall of said assistance chamber (16), so that said substrate can be placed on said substrate stage (63) via said substrate loading/unloading port (25) while said substrate stage (63) is positioned in said assistance chamber (16).

8. The vacuum processing apparatus (2) according to one of the claims 1 to 7, wherein a heating device (19) is provided in said vacuum vessel (10) for heating said reaction chamber (14) and said assistance chamber (16).

9. A multi-chamber vacuum processing apparatus (90) comprising:
the vacuum processing apparatus (2) according to one of the claims 1 to 8;
a heating chamber(96) for heating a substrate in vacuum atmosphere; and
a transfer chamber (50) in which the substrate is moved in vacuum atmosphere, wherein said vacuum processing apparatus (2) and said heating chamber (96) are connected to said transfer chamber (50).

10. The multi-chamber vacuum processing apparatus (90) according to claim 9, wherein a sputtering apparatus (93) is connected to said transfer chamber (50).

## Patentansprüche

1. Vakuumbehandlungsvorrichtung (2), umfassend:
einen Vakuumbehälter (10);
eine Substratstufe (13), die in dem Vakuumbehälter (10) angeordnet ist;
einen Stufenbewegungsmechanismus (29) zum Bewegen der Substratstufe (63) innerhalb des Vakuumbehälters (10);
ein Vakuumpumpensystem (20) zum Evakuieren des Inneren des Vakuumbehälters; und
ein Gaseinleitungssystem (30) zum Einleiten von Gas in den Vakuumbehälter, worin der Vakuumbehälter (10) in eine Reaktionskammer (14) und eine Hilfskammer (16) unterteilt ist, die miteinander in Verbindung stehen, während ein Evakuierungsleitwert, wenn ein auf der Substratstufe (63) angeordnetes Substrat in der Reaktionskammer (14) platziert ist, niedriger ist als ein Evakuierungsleitwert, wenn die Substratstufe (63) in der Hilfskammer (16) platziert ist, worin ein ringförmiges Kontaktelement (53) an einer Innenwandfläche des Vakuumbehälters (10) zwischen der Reaktionskammer (14) und der Hilfskammer (16) bereitgestellt ist, wenn die Substratstufe (63) in Richtung der Reaktionskammer (14) bewegt wird, das auf einer Oberfläche der Substratstufe (63) angeordnete Substrat einer Innenseite der Reaktionskammer (14) durch eine mittlere Stelle des Kontaktelements ausgesetzt ist, und gleichzeitig ein Kontaktteil (68) der Substratstufe (63) und das Kontaktelement (53) in engen Kontakt miteinander gebracht sind,
**dadurch gekennzeichnet, dass** kleine Löcher (54) in dem Kontaktelement (53) bereitgestellt sind, so dass, wenn der Kontaktteil (68) der Substratstufe (63) und das Kontaktelement (53) in engen Kontakt miteinander gebracht sind, die Reaktionskammer (14) und die Hilfskammer (16) miteinander über die kleinen Löcher (54) in Verbindung stehen.

2. Vakuumbehandlungsvorrichtung (2) gemäß Anspruch 1, worin das Gaseinleitungssystem (30) mit der Reaktionskammer (14) verbunden ist.

3. Vakuumbehandlungsvorrichtung (2) gemäß Anspruch 2, worin das Gaseinleitungssystem (30) derart gebildet ist, das Gas durch das obere Ende der Reaktionskammer (14) einzuleiten.

4. Vakuumbehandlungsvorrichtung (2) gemäß Anspruch 3, worin das Gaseinleitungssystem (30) mit einem Gaserzeugungssystem (35) bereitgestellt ist, das ein Rohmaterialgas erzeugt, das eine Organometallverbindung umfasst, wobei das Rohmaterialgas in die Reaktionskammer (14) eingeleitet wird.

5. Vakuumbehandlungsvorrichtung (2) gemäß einem der Ansprüche 1 bis 4, worin die Hilfskammer (16) unter der Reaktionskammer (14) angeordnet ist.

6. Vakuumbehandlungsvorrichtung (2) gemäß einem der Ansprüche 1 bis 5, worin das Vakuumpumpensystem (20) mit der Hilfskammer (16) verbunden ist, so dass das in die Reaktionskammer (14) eingeleitete Gas durch die Hilfskammer (16) ausgepumpt wird.

7. Vakuumbehandlungsvorrichtung (2) gemäß einem der Ansprüche 1 bis 6, worin eine Substratlade-/Substratentladeöffnung (25) in der Wand der Hilfskammer (16) bereitgestellt ist, so dass das Substrat auf die Substratstufe (63) über die Substratlade-/Substratentladeöffnung (25) gebracht werden kann, während die Substratstufe (63) in der Hilfskammer (16) platziert ist.

8. Vakuumbehandlungsvorrichtung (2) gemäß einem der Ansprüche 1 bis 7, worin eine Heizvorrichtung (19) in dem Vakuumbehälter (10) zum Beheizen der Reaktionskammer (14) und der Hilfskammer (16) bereitgestellt ist.

9. Mehrkammer-Vakuumbehandlungsvorrichtung (90), umfassend:
die Vakuumbehandlungsvorrichtung (2) gemäß einem der Ansprüche 1 bis 8;
eine Heizkammer (96) zum Erhitzen eines Substrats in Vakuumatmosphäre; und
eine Übergabekammer (50), in die das Substrat in Vakuumatmosphäre bewegt wird, worin die Vakuumbehandlungsvorrichtung (2) und die Heizkammer (96) mit der Übergabekammer (50) verbunden sind.

10. Mehrkammer-Vakuumbehandlungsvorrichtung (90) gemäß Anspruch 9, worin eine Sputtervorrichtung (93) mit der Übergabekammer (50) verbunden ist.

## Revendications

1. Dispositif de traitement sous vide (2) comprenant :
une cuve à vide (10) ;
un étage de substrat (13) disposé dans ladite cuve à vide (10) ;
un mécanisme de déplacement d'étage (29) pour déplacer ledit étage de substrat (63) dans ladite cuve à vide (10) ;
un système de pompage de vide (20) pour évacuer l'intérieur de ladite cuve à vide ; et
un système d'introduction de gaz (30) pour introduire du gaz dans ladite cuve à vide,
où ladite cuve à vide (10) est divisée en une chambre de réaction (14) et une chambre d'assistance (16) qui communiquent l'une avec l'autre, pendant qu'une conductance d'évacuation, lorsqu'un substrat placé sur ledit étage de substrat (63) est positionné dans ladite chambre de réaction (14) est plus basse qu'une conductance d'évacuation lorsque ledit étage de substrat (63) est positionné dans ladite chambre d'assistance (16), où un élément de contact annulaire (53) est prévu sur une surface de paroi intérieure de ladite cuve à vide (10) entre ladite chambre de réaction (14) et ladite chambre d'assistance (16), lorsque ledit étage de substrat (63) est déplacé vers ladite chambre de réaction (14), ledit substrat placé sur une surface dudit étage de substrat (63) est exposé à l'intérieur de ladite chambre de réaction (14) à travers une position centrale dudit élément de contact et, en même temps, une portion de contact (68) dudit étage de substrat (63) et dudit élément de contact (53) sont amenés en contact étroit l'un avec l'autre,
**caractérisé en ce que** de petits trous (54) sont réalisés dans ledit élément de contact (53) de telle sorte que, lorsque la portion de contact (68) dudit étage de substrat (63) et ledit élément de contact (53) sont amenés en contact étroit l'un avec l'autre, ladite chambre de réaction (14) et ladite chambre d'assistance (16) communiquent l'une avec l'autre par les petits trous précités (54).

2. Dispositif de traitement sous vide (2) selon la revendication 1, où ledit système d'introduction de gaz (30) est relié à ladite chambre de réaction (14).

3. Dispositif de traitement sous vide (2) selon la revendication 2, où ledit système d'introduction de gaz (30) est constitué de façon à introduire le gaz à travers le dessus de ladite chambre de réaction (14).

4. Dispositif de traitement sous vide (2) selon la revendication 3, où ledit système d'introduction de gaz (30) présente un système de génération de gaz (35) qui produit un gaz de matière brute comprenant un composé organométallique, le gaz de matière brute étant introduit dans ladite chambre de réaction (14).

5. Dispositif de traitement sous vide (2) selon l'une des revendications 1 à 4, où ladite chambre d'assistance (16) est disposée en dessous de ladite chambre de réaction (14).

6. Dispositif de traitement sous vide (2) selon l'une des revendications 1 à 5, où ledit système de pompage de vide (20) est relié à ladite chambre d'assistance (16) de telle sorte que le gaz introduit dans ladite chambre de réaction (14) est évacué à travers ladite chambre d'assistance (16).

7. Dispositif de traitement sous vide (2) selon l'une des revendications 1 à 6, où un orifice de chargement/déchargement de substrat (25) est réalisé dans la paroi de ladite chambre d'assistance (16) de sorte que ledit substrat peut être placé sur ledit étage de substrat (63) à travers ledit orifice de chargement/déchargement de substrat (25) pendant que ledit étage de substrat (63) est positionné dans ladite chambre d'assistance (16).

8. Dispositif de traitement sous vide (2) selon l'une des revendications 1 à 7, où un dispositif de chauffage (19) est prévu dans ladite cuve à vide (10) pour chauffer ladite chambre de réaction (14) et ladite chambre d'assistance (16) .

9. Dispositif de traitement sous vide à chambres multiples (90) comprenant :
le dispositif de traitement sous vide (2) selon l'une des revendications 1 à 8 ;
une chambre de chauffage (96) pour chauffer un substrat dans l'atmosphère de vide ; et
une chambre de transfert (50) dans laquelle le substrat est déplacé dans l'atmosphère de vide ;
où ledit dispositif de traitement sous vide (2) et ladite chambre de chauffage (96) sont reliés à ladite chambre de transfert (50) .

10. Dispositif de traitement sous vide à chambres multiples (90) selon la revendication 9, où un appareil de pulvérisation cathodique (93) est relié à ladite chambre de transfert (50).
